# EUROPEAN PATENT APPLICATION

(11) **EP 4 269 089 A1**
(43) Date of publication of application: **01.11.2023**
(21) Application number: 21910564.0
(22) Date of filing: 16.12.2021
(51) Int. Cl.: B32B 9/00, B65D 65/40, C23C 14/08

(54) **GAS BARRIER MULTILAYER BODY AND PACKAGING MATERIAL**

(30) Priority: 22.12.2020 JP 2020212255
(71) Applicant: DIC Corporation, Tokyo 174-8520 (JP)
(72) Inventor: HARADA Tomoaki, Sakura-shi, Chiba 285-8668 (JP); KAGAYA Hiroyuki, Tokyo 174-8520 (JP); HAYASHI Masanori, Tokyo 174-8520 (JP)
(74) Representative: Beckmann, Claus
(86) International application number: PCT/JP2021/046416
(87) International publication number: WO 2022/138416

(57) **Abstract**

An object of the present invention is to provide a gas barrier laminated material which can be produced through a simple and easy process, and which can achieve stable gas barrier properties even at high humidity. The present inventors have made a gas barrier laminated material having a metal layer (A) formed by a vapor phase thin film formation method and a layer (B) formed from a compound having a carboxyl group in the structure thereof, wherein the metal layer (A) and the layer (B) are laminated, and thus can achieve a gas barrier laminated material which can be produced through a simple and easy process, and which can achieve stable gas barrier properties even at high humidity, and have solved the problems.

## Description

### TECHNICAL FIELD

The present invention relates to a gas barrier laminated material having a metal layer (A) formed by a physical vapor deposition method and a layer (B) formed from a compound having a carboxyl group in the structure thereof, wherein the metal layer (A) and the layer (B) are laminated.

### BACKGROUND ART

The packaging materials used for packaging foods, pharmaceuticals, and the like are required to have barrier properties with respect to oxygen or water vapor (hereinafter, referred to as "gas barrier properties") for the purpose of preventing oxidation from causing a change of the contents or taste and deterioration of the performance quality.

As a substrate used for the packaging material, a transparent resin film having the surface subjected to deposition treatment has been used because such a resin film is inexpensive and can impart high barrier performance to a packaging material.

With respect to the deposition treatment, a treatment for depositing AlOx, SiOx, or the like has been widely used, but the deposited film obtained by the treatment has such a low resistance to twisting, folding, and the like that the film easily breaks, and therefore the deposited film is coated with a resin having a highly hydrophilic hydrogen bonding group before being used.

However, there is a problem in that the resin having a highly hydrophilic hydrogen bonding group used in the coating exhibits excellent gas barrier properties under dry conditions, but the gas barrier properties become poor under high humidity conditions due to the hydrogen bonding group present in the resin.

As a method for solving the above-mentioned problem, a method is employed in which a deposition treated substrate is coated with an alcohol dispersion of a polycarboxylic acid polymer and a bivalent metal salt to form a polycarboxylic acid multivalent metal salt on the surface of the substrate, but another problem arises in that the coating increases the number of the steps.

### CITATION LIST

### PATENT LITERATURE

PTL 1: JP2007-112114A

### SUMMARY OF INVENTION

### TECHNICAL PROBLEM

In this situation, the present inventors have made studies on the gas barrier laminated material which can be produced through a simple and easy process, and which can achieve stable gas barrier properties even at high humidity.

### SOLUTION TO PROBLEM

The present inventors have conducted extensive and intensive studies. As a result, it has been found that the above-mentioned problems can be solved by the gas barrier laminated material having a metal layer (A) formed by a vapor phase thin film formation method and a layer (B) formed from a compound having a carboxyl group in the structure thereof, wherein the metal layer (A) and the layer (B) are laminated, and the present invention has been completed.

### ADVANTAGEOUS EFFECTS OF INVENTION

In the present invention, there can be obtained a gas barrier laminated material which can be produced through a simple and easy process, and which can achieve stable gas barrier properties even at high humidity.

### DESCRIPTION OF EMBODIMENTS

The present invention is directed to a gas barrier laminated material having a metal layer (A) formed by a vapor phase thin film formation method and a layer (B) formed from a compound having a carboxyl group in the structure thereof, wherein the metal layer (A) and the layer (B) are laminated.

Further, in the gas barrier laminated material, the metal layer (A) may be a layer formed from at least one member selected from the group consisting of a metal oxide, a metal hydroxide, and a metal salt.

Furthermore, in the gas barrier laminated material, the metal layer (A) may be a metal layer formed from at least one metal oxide selected from zinc oxide, magnesium oxide, and calcium oxide.

In addition, the gas barrier laminated material may have a feature such that the vapor phase thin film formation method is a physical vapor deposition method.

Further, the gas barrier laminated material may have a feature such that, as the polycarboxylic acid compound used in the gas barrier laminated material, a polycarboxylic acid compound having two or more carboxyl groups in the molecule thereof is used.

Furthermore, the gas barrier laminated material may have a feature such that the gas barrier laminated material has a resin film substrate layer.

Further, the present invention is directed to a packaging material comprising the gas barrier laminated material.

The gas barrier laminated material of the invention has a metal layer (A) formed by a vapor phase thin film formation method. With respect to the vapor phase thin film formation method used for forming the metal layer in the invention, there are a physical vapor deposition method (hereinafter, referred to as "PVD method"), such as a vacuum deposition method, a sputtering method, or an ion plating method, and a chemical vapor deposition method (hereinafter, referred to as "CVD method"), and any of these methods may be used as long as the effects of the invention can be obtained. As mentioned above, with respect to the vapor phase thin film formation method used in the invention, there is no particular limitation, but, in view of enabling formation of a stable thin film with ease, it is preferred that the metal layer is produced by a PVD method, such as a vacuum deposition method, a sputtering method, or an ion plating method, and further it is most preferred that thin film formation is conducted by a vacuum deposition method.

With respect to the metal used for forming the metal layer in the invention, there is no particular limitation as long as the effects of the invention can be obtained, and at least one member selected from a metal, a metal oxide, a metal hydroxide, and a metal salt, which are capable of imparting gas barrier properties, can be used. In view of achieving excellent gas barrier properties, the metal is preferably at least one member selected from zinc oxide, magnesium oxide, calcium oxide, manganese oxide, iron oxide, cobalt oxide, nickel oxide, and copper oxide, further preferably at least one member selected from zinc oxide, magnesium oxide, and calcium oxide, especially preferably zinc oxide. These metal compounds may be used individually or in combination.

With respect to the thickness of the metal layer (A) in the invention, there is no particular limitation as long as the effects of the invention can be obtained, and the metal layer (A) may have any thickness as long as the effects of the invention can be obtained. As mentioned above, there is no particular limitation with respect to the thickness of the metal layer (A), but the thickness of the metal layer (A) is preferably 1 to 100 nm in view of obtaining satisfactory gas barrier properties, further preferably 3 to 70 nm in view of surely achieving plasticity of the whole of gas barrier laminated material, especially preferably 5 to 60 nm.

With respect to the vapor deposition processing used as the PVD method, a method is used in which a target, for example, a metal, a metal oxide, a metal hydroxide, or a resin (hereinafter, these raw materials for vapor deposition are frequently collectively referred to as "target") is evaporated by heating using a certain type of heat source, and deposited in the form of droplets or crystals on the surface of a substrate kept at a lower temperature. The method can be used in any of a batchwise manner in which the entire surface to be processed is treated at the same time and a manner in which the substrate or a reaction tank is moved to continuously treat the substrate and continuously treat different surfaces to be processed.

The vapor deposition processing in the invention can be conducted in an atmosphere of any of air and an inert gas under a pressure, atmospheric pressure, or a reduced pressure or in a vacuum state or swing thereof. When the treatment is performed under a reduced pressure or in a vacuum state, an improvement of the evaporation rate and reduction of the evaporation temperature can be achieved, and, when the treatment is conducted under a pressure, deposition of the evaporated material can be promoted. Further, when the treatment is performed in a vacuum or in an inert atmosphere, oxidation of the metal, metal oxide, metal hydroxide, or the like or a carrier can be controlled. Furthermore, when oxidation is controllable or acceptable in the vapor deposition step, vapor deposition can be conducted in an air atmosphere in view of the cost.

In the invention, a preferred thin film can be obtained according to the purpose by controlling the conditions for vapor deposition. The conditions for vapor deposition, which are for controlling the chemical structure of the target deposited material, include a pressure in a chamber and a period of time during which the target vapor, molecules present in the atmosphere, and the surface of a substrate are in contact, and controlling the time enables control of the composition of the deposited thin film to be formed. Further, the structure of the surface of the thin film can be controlled by permitting the formed thin film to be in contact with oxygen or water vapor.

The wording "controlling the chemical structure of the target deposited material" means that, for example, by adding water vapor or oxygen during the vapor deposition, a compound containing the target metal having a hydroxyl group or oxygen added thereto can be obtained as a deposited layer, and the conditions for vapor deposition can be appropriately studied according to a desired deposited film.

With respect to the sputtering method in the invention, there is no particular limitation as long as the effects of the invention can be obtained, and the sputtering method can be selected from DC sputtering, RF sputtering, magnetron sputtering, ion beam sputtering, RF magnetron sputtering, and the like, but, in view of achieving sputtering with high efficiency, a method using magnetron sputtering or RF magnetron sputtering is preferred. It is desired that magnetron sputtering is conducted in a treatment space, such as a chamber which is evacuated to, for example, 1 × 10⁻⁴ Pa or less, and into which an inert gas (e.g., argon) is introduced. In the treatment space, a target, which is a raw material for a thin film, and a substrate are arranged so that they face to each other. On the backside of the target, a permanent magnet and, if necessary, a jig, such as a holding fixture for holding the target, are disposed.

The magnetic field due to the permanent magnet can bind the helical orbital of electrons present in the treatment space, generating a plasma region with high density. The high density plasma region present in the treatment space promotes ionization of the inert gas, and the resultant ions hit the target to generate fine particles of the target, and the generated fine particles are deposited on the substrate, forming a thin film.

With respect to the ratio frequency output for conducting RF magnetron sputtering, there is no particular limitation, and the output may be selected from the viewpoint of achieving an appropriate film formation rate. Further, it is desired that the temperature of the substrate during the film formation is controlled to room temperature to about 100°C.

With respect to the compound having a carboxyl group in the structure thereof used for forming the layer (B) in the invention, there is no particular limitation as long as the effects of the invention can be obtained, but the compound can be selected from a monocarboxylic acid compound, a polycarboxylic acid compound, a resin having a carboxyl substituent, and the like.

The compound having a carboxyl group is preferably a polycarboxylic acid compound in view of advantageously exhibiting barrier properties, and there can be used citric acid, mellitic acid, trimellitic acid, succinic acid, butanetetracarboxylic acid, benzenepentacarboxylic acid, benzenehexacarboxylic acid, a salt thereof, or the like. At least one polycarboxylic acid having two or more carboxyl groups in the molecule thereof is preferably used because excellent gas barrier properties can be obtained, and at least one member selected from the group consisting of citric acid, butanetetracarboxylic acid, succinic acid, and trimellitic acid is further preferably used.

When the layer (B) is formed using the monocarboxylic acid compound or polycarboxylic acid compound in the invention, the compound, which is dissolved in a solvent, may be applied onto the substrate by an application method that has been conventionally known and commonly used, such as a roll coating method, a spraying method, a spin coating method, a blade coating method, a dipping method, a screen printing method, an inkjet method, a doctor roll method, a doctor blade method, a curtain coating method, a slit coating method, or a dispensing method. Examples of the solvents include solvents, such as an aqueous solvent and a nonaqueous solvent, and an additive, such as a resin, a coupling agent, a silane compound, a phosphoric acid compound, an organic filler, an inorganic filler, a stabilizer (such as an antioxidant, a heat stabilizer, or an ultraviolet light absorber), a plasticizer, an antistatic agent, a lubricant, an anti-blocking agent, a coloring agent, a crystal nucleating agent, an oxygen scavenger, or a tackifier, may be added to the solvent.

When the layer (B) is formed using the monocarboxylic acid compound or polycarboxylic acid compound in the invention, with respect to the thickness of the layer (B), there is no particular limitation as long as the effects of the invention can be obtained, but the thickness of the layer (B) is preferably 5 to 1,000 nm in view of obtaining satisfactory gas barrier properties, further preferably in the range of from 10 to 500 nm in view of achieving both flexibility and fastness.

When the resin having a carboxyl group is used for forming the layer (B) in the invention, the resin having a carboxyl group may be used as a substrate.

For the purpose of improving the application properties, a solvent, such as an aqueous solvent or a nonaqueous solvent, or an additive, such as a resin, a coupling agent, a silane compound, a phosphoric acid compound, an organic filler, an inorganic filler, a stabilizer (such as an antioxidant, a heat stabilizer, or an ultraviolet light absorber), a plasticizer, an antistatic agent, a lubricant, an anti-blocking agent, a coloring agent, a crystal nucleating agent, an oxygen scavenger, or a tackifier, may be added to the layer (B) as long as the effects of the invention can be obtained.

With respect to the solvent which can be added to the layer (B), preferred is a solvent capable of dissolving the polycarboxylic acid monomer to be used, and, specifically, there can be used water, an alcohol, such as ethanol, methanol, 2-propanol, ethylene glycol, glycerol, capryl alcohol, lauryl alcohol, myristyl alcohol, cetyl alcohol, stearyl alcohol, or oleyl alcohol, an ester, such as methyl acetate, ethyl acetate, pentyl acetate, octyl acetate, methyl butyrate, ethyl butyrate, pentyl butyrate, methyl salicylate, ethyl salicylate, pentyl salicylate, methyl formate, ethyl formate, or pentyl formate, or the like, and, in view of easy drying of the layer after applied, preferred is ethanol or ethyl acetate.

Further, with respect to the amount of the polycarboxylic acid monomer added, there is no particular limitation as long as the gas barrier properties in the invention can be obtained, but the amount of the polycarboxylic acid monomer added is preferably 30 wt% 80 wt%, especially preferably 35 wt% 75 wt%, based on the weight of the solids of the layer (B).

The gas barrier laminated material of the invention may have a construction in which the layer (A) and the layer (B) are laminated on a certain type of substrate, such as a resin film, and, when a resin having a carboxyl group is used as the layer (B), the gas barrier laminated material may have a construction in which only the layer (A) and the layer (B) are laminated on one another.

In the invention, when the gas barrier laminated material has the layer (A) and the layer (B) which are laminated on a substrate layer, such as a film, with respect to the order of lamination of the layer (A) and the layer (B), there is no particular limitation as long as the effects of the invention can be obtained, but, in view of facilitating the lamination processing, the gas barrier laminated material preferably has the layer (A) and the layer (B) which are successively laminated on a substrate layer.

With respect to the substrate used in the invention, such as a film, there is no particular limitation as long as the gas barrier effects aimed at by the invention can be obtained, and the substrate can be appropriately selected by those skilled in the art according to the desired application. With respect to the substrate, at least one film of a resin, such as a polyolefin resin, a polyester resin, a polyamide resin, a resin having a carboxyl substituent, a polystyrene resin, or a polyvinyl resin, or at least one substrate selected from paper, wood, a metal, a metal oxide, silicon, modified silicon, and the like can be selected and used, and, in view of advantageously obtaining the gas barrier effects aimed at by the invention, a resin film or paper is preferred, and a resin film is especially preferred. The above-mentioned substrate having an anchor coat layer formed on the surface thereof can be used. Further, as the resin film, an oriented film or an unoriented film may be used.

With respect to the form, hardness, thickness, and the like of the substrate, there is no particular limitation, and a substrate of a flat plate form, sheet form, solid or cubic form, or the like is selected according to the purpose, and the hardness, thickness, and the like of the substrate used can be appropriately selected.

The substrate may contain an additive if necessary. For the purpose of improving or modifying, for example, processability, heat resistance, weathering resistance, mechanical properties, dimensional stability, resistance to oxidation, slip properties, releasability, flame retardancy, mildew resistance, electrical properties, strength, or the like, a plastic compounding agent or an additive, such as a lubricant, a crosslinking agent, an antioxidant, an ultraviolet light absorber, a light stabilizer, a filler, a reinforcement, an antistatic agent, or a pigment, can be added to the substrate. The amount of the additive added can be appropriately selected as long as the gas barrier effects aimed at by the invention can be obtained.

In the invention, when the layer (A) and layer (B) are laminated and then dried, the gas barrier properties can be improved. With respect to the drying method for these layers after being applied, there is no particular limitation as long as the layers can be dried, but a drying method, such as room temperature drying, heating, vacuum drying, or air blast, can be used.

The gas barrier laminated material of the invention may be in the form of a multilayer laminated material which is obtained by further laminating a substrate, the layer (A), layer (B) and/or another coating layer on one side or both sides of the laminated material. In the invention, with respect to the application method for the layer (A) and layer (B), there is no particular limitation, and an application method that has been conventionally known and commonly used, such as a roll coating method, a spraying method, a spin coating method, a blade coating method, a dipping method, a screen printing method, an inkjet method, a doctor roll method, a doctor blade method, a curtain coating method, a slit coating method, or a dispensing method, can be used.

The gas barrier laminated material of the invention has excellent gas barrier properties, and therefore can be advantageously used as various types of packaging materials. Particularly, the gas barrier laminated material of the invention can be used in packaging applications that require gas barrier properties, such as packaging materials for foods, articles for daily use, electronic materials, and products for medical use. The gas barrier laminated material of the invention further has excellent heat resistance and excellent resistance to moist heat, and therefore can also be advantageously used as a packaging material for heating sterilization, such as a boiling or retort packaging material. The packaging material of the invention is obtained using the laminated material of the invention by stacking together the sides of the sealant film of the laminated material and then heat-sealing the ends of the laminated material. As a method for producing a bag, there can be mentioned a method in which the laminated material of the invention is folded or stacked on another one so that the sides of the inner layers (the sides of the sealant film) face each other, and the ends of the laminated material are heat-sealed into a form of, for example, a side sealed type, a two-side sealed type, a three-side sealed type, a four-side sealed type, an envelope sealed type, a gassho (back line) sealed type (vertical pillow, horizontal pillow), a ribbed sealed type, a flat bottom sealed type, a square bottom sealed type, a gusseted type, or another heat-sealed type. The packaging material of the invention can be in various forms according to the contents, the environment for use, or the form for use. The packaging material of the invention can be in the form of a self-supporting packaging material (standing pouch) or the like. As a method for heat-sealing, heat-sealing can be conducted by a known method, such as bar sealing, rotating roll sealing, belt sealing, impulse sealing, radiofrequency sealing, or ultrasonic sealing.

The packaging material of the invention is filled with contents through the opening thereof, and then the opening is heat-sealed to produce a product using the packaging material of the invention. Examples of contents filling the packaging material include confectionery, such as rice confectionery, bean confectionery, nuts, biscuits or crackers, wafer confectionery, marshmallow, pie, half baked cake, candy, and snacks; staple foods, such as bread, snack noodle, instant noodle, dried noodle, pasta, aseptic packaged cooked rice, a porridge of rice and vegetables, rice gruel, packaged rice cake, and cereal foods; processed agricultural products, such as pickles, cooked beans, fermented soybeans, miso, dried bean curd, bean curd, nametake mushroom, konjakjerry (devil's tongue), processed edible wild plant products, jam, peanut cream, salad, frozen vegetables, and processed potato products; processed livestock products, such as ham, bacon, sausage, chicken processed products, and corned beef; processed marine products, such as fish ham and sausage, fish-paste products, boiled fish paste, laver, food boiled down in soy, dried bonito, salted fish guts, smoked salmon, and spicy seasoned cod roe; fruits, such as peach, mandarin orange, pineapple, apple, pear, and cherry; vegetables, such as corn, asparagus, mushroom, onion, carrot, daikon radish, and potato; cooked foods, e.g., frozen daily dishes and chilled daily dishes, such as hamburger, meatball, marine product fry, dumping stuffed with minced pork, and croquette; dairy products, such as butter, margarine, cheese, cream, instant full cream milk powder, and infant formula powdered milk; and foods, such as liquid seasoning, retort-pouch curry, and pet food. Further, the packaging material of the invention can be used as a packaging material for cigarettes, a disposable body warmer, pharmaceuticals, such as a transfusion pack, cosmetics, a vacuum heat insulating material, and the like.

Hereinbelow, the present invention will be described in more detail with reference to the following Examples, which should not be construed as limiting the scope of the present invention.

### EXAMPLES

Hereinbelow, the present invention will be described in detail with reference to the following Examples, which should not be construed as limiting the scope of the present invention.

### (Production Examples 1 to 3)

As a sputtering machine, a magnetron sputtering machine (model EB1100, manufactured by Canon Anelva Corporation) was used.

As a target, a zinc oxide target was used, and, as a substrate film, a transparent deposited PET film (Barrialox 1011HG, manufactured by Toray Advanced Film Co., Ltd.) was used.

Using argon as process gas, a zinc oxide deposited layer was formed. The power for the sputter power source was 5.0 W/cm², and the pressure for film formation was 0.4 Pa. The oxygen partial pressure was 10%. The deposition time was controlled so that the layers in Production Examples 1 to 3 having the thicknesses shown in Table 1 were obtained.

### (Production Example 4)

A magnesium oxide deposited layer was formed using magnesium oxide as a target under the same conditions as those in Production Examples 1 to 3.

### (Production Example 5)

A calcium oxide deposited layer was formed using calcium oxide as a target under the same conditions as those in Production Examples 1 to 3.

### (Production Example 6)

As a PVD apparatus, in a vacuum deposition apparatus (VPC-1100, manufactured by ULVAC TECHNO, Ltd.) that can conduct EB heating and resistance heating, zinc oxide as a target was placed in a crucible, and the apparatus was evacuated to the vacuum degree of 3.0 × 10⁻³ Pa, and the target was heated so that film formation at a rate in the range of from 10 to 500 A/s could be made while checking the film formation rate by a quartz crystal unit. The film formation time was controlled so that the layers in Production Examples 6 to 8 having the thicknesses shown in Table 2 were obtained.

As process gas, an extremely small amount of oxygen or water vapor was introduced.

### <Preparation method for resin solution>

### (Preparation Example 1 for resin solution)

50 g of a polyvinyl alcohol (hereinafter, frequently referred to simply as "PVA") powder (KURARAY POVAL 60-98, manufactured by Kuraray Co., Ltd.) was dissolved in 950 g of ion-exchanged water in a flask while heating and stirring to obtain a preparation liquid 1 having a solids content of 5%.

### (Preparation Example 2 for resin solution)

20 g of a polyacrylic acid powder (Acryset AS-58, manufactured by Nippon Shokubai Co., Ltd.) was dissolved in 980 g of isopropanol in a flask while heating and stirring to obtain a preparation liquid 2 having a solids content of 2%.

### (Example 1)

37 g of the preparation liquid 1 obtained in Preparation Example 1 for resin solution, 1.85 g of citric acid, and 59 g of water were mixed to obtain a coating liquid 1. The obtained coating agent was applied to the deposition surface of a transparent deposited PET film having deposited thereon ZnO with a thickness of 100 nm using a bar coater so that the thickness of the applied coating agent after being dried became about 0.4 g/m². Immediately after the application, the resultant film was heated in a dryer at 80°C for two minutes to prepare a laminated material. The obtained laminated material was subjected to aging in a dryer at 40°C for one day, and then gas barrier properties of the laminated material were evaluated.

In Examples 2 to 11, a substrate having deposited thereon ZnO with the thickness shown in Table 1 and a coating liquid were prepared, and a laminated material was produced by the same method as that in Example 1 and evaluation was made. The results are shown in Table 1.

### (Examples 12 to 14)

37 g of the preparation liquid 1, 1.85 g of citric acid, and 59 g of water were mixed to obtain a coating liquid 1. The obtained coating agent was applied to the deposition surface of a transparent deposited PET film (Barrialox 1011HG, manufactured by Toray Advanced Film Co., Ltd.; thickness: 12 µm) using a bar coater so that the thickness of the applied coating agent after being dried became about 0.4 g/m². Immediately after the application, the resultant film was heated in a dryer at 80°C for two minutes to prepare a resin coat film. According to substantially the same method as that in Production Examples 1 to 3 except that the resin coat film was used as a substrate, the deposition time was controlled so that films (Examples 12 to 14) having the thicknesses shown in Table 1 were obtained.

### (Example 15)

The preparation liquid 2 obtained in Preparation Example 2 for resin solution was applied to the deposition surface of a transparent deposited PET film having deposited thereon ZnO with a thickness of 100 nm using a bar coater so that the thickness of the applied preparation liquid after being dried became about 0.4 g/m². Immediately after the application, the resultant film was heated in a dryer at 80°C for one minute to prepare a laminated material. The obtained laminated material was subjected to aging in a dryer at 40°C for one day, and then gas barrier properties of the laminated material were evaluated.

### (Comparative Example 1)

The coating liquid 1 which is the same as used in Example 1 was prepared, and applied to the deposition surface of a transparent deposited PET film having no ZnO deposited (Barrialox 1011HG, manufactured by Toray Advanced Film Co., Ltd.; thickness: 12 µm) using a bar coater so that the thickness of the applied coating liquid after being dried became about 0.4 g/m². Immediately after the application, the resultant film was heated in a dryer at 80°C for two minutes to prepare a laminated material. The obtained laminated material was subjected to aging in a dryer at 40°C for one day, and then gas barrier properties of the laminated material were evaluated.

### (Comparative Example 2)

The preparation liquid 1 was applied to the deposition surface of a transparent deposited PET film having deposited thereon ZnO with a thickness of 100 nm using a bar coater so that the thickness of the applied preparation liquid after being dried became about 0.4 g/m². Immediately after the application, the resultant film was heated in a dryer at 80°C for two minutes to prepare a laminated material. The obtained laminated material was subjected to aging in a dryer at 40°C for one day, and then gas barrier properties of the laminated material were evaluated.

### (Comparative Example 3)

150 g of ZnO having a primary particle diameter of 20 nm (FINEX-50, manufactured by Sakai Chemical Industry Co., Ltd.) and 850 g of IPA were mixed together, and dispersed in a bead mill (Labostar Mini LMZ015, manufactured by Ashizawa Finetech Ltd.) using zirconia beads having a diameter of 0.3 mm for one hour, and then the beads were removed by sieving to obtain a ZnO solution having a solids content of 15%. ZnO in the obtained dispersion had a particle diameter of 88 nm. The ZnO dispersion was applied to a transparent deposited PET film (Barrialox 1011HG, manufactured by Toray Advanced Film Co., Ltd.; thickness: 12 µm) using a bar coater so that the thickness of the applied dispersion after being dried became about 0.4 g/m². Immediately after the application, the resultant film was heated in a dryer at 80°C for one minute to prepare a laminated material. Then, the coating liquid 1 which is the same as used in Example 1 was prepared, and applied to the ZnO applied surface of the formed film using a bar coater so that the thickness of the applied coating liquid after being dried became about 0.4 g/m². Immediately after the application, the resultant film was heated in a dryer at 80°C for two minutes to prepare a laminated material. The obtained laminated material was subjected to aging in a dryer at 40°C for one day, and then gas barrier properties of the laminated material were evaluated.

### <Evaluation of gas barrier properties: Oxygen transmission rate>

An oxygen transmission rate was measured using Oxygen Transmission Rate measurement apparatus OX-TRAN2/21 manufactured by Mocon Inc. in an atmosphere at a temperature of 23°C and at a humidity of 0% RH and in an atmosphere at a temperature of 23°C and a humidity of 90% RH in accordance with JIS-K7126 (equal-pressure method). RH indicates relative humidity. The unit of the oxygen transmission rate is cc/day·atm·m².

### <Evaluation of gas barrier properties: Water vapor transmission rate>

A water vapor transmission rate (MVTR) was measured using Water Vapor Transmission Rate measurement apparatus 7001 manufactured by Systech Illinois Inc. in an atmosphere at a temperature of 40°C and at a humidity of 90% RH in accordance with JIS-K7129. The unit of the oxygen transmission rate is g/m²·day.

The constructions of the laminated materials in the Examples and Comparative Examples and the results of the evaluation of barrier properties are shown in Tables 1 to 3.

**[Table 1]**

| | Example No. | | Example 1 | Example 2 | Example 3 | Example 4 | Example 5 | Example 6 | Example 7 | Example 8 |
|---|---|---|---|---|---|---|---|---|---|---|
| Metal layer (A) | Production Example | | Production Example 1 | Production Example 2 | Production Example 3 | Production Example 4 | Production Example 5 | Production Example 1 | Production Example 1 | Production Example 1 |
| | Metal | | Zinc oxide | Zinc oxide | Zinc oxide | Magnesium oxide | Calcium oxide | Zinc oxide | Zinc oxide | Zinc oxide |
| | Method | | Sputtering | Sputtering | Sputtering | Sputtering | Sputtering | Sputtering | Sputtering | Sputtering |
| | Thickness (nm) | | 100 | 50 | 20 | 100 | 100 | 100 | 100 | 100 |
| Layer (B) | Preparation liquid 1 | | 37 | 37 | 37 | 37 | 37 | 37 | 37 | 37 |
| | Preparation liquid 2 | | | | | | | | | |
| | Water | | 59 | 59 | 59 | 59 | 59 | 59 | 59 | 59 |
| | Succinic acid | | | | | | | 4.3 | | |
| | BTCA | | | | | | | | 4.3 | |
| | Citric acid | | 1.85 | 1.85 | 1.85 | 1.85 | 1.85 | | | 4.3 |
| | Polycarboxylic acid in solids | | 50% | 50% | 50% | 50% | 50% | 70% | 70% | 70% |
| Evaluation of barrier properties | OTR | 0%RH | 0.04 | 0.1 | 0.1 | 0.1 | 0.1 | 0.1 | 0.05 | 0.08 |
| | | 90%RH | 0.1 | 0.5 | 0.8 | 1.6 | 1.8 | 0.2 | 0.1 | 0.1 |
| | MVTR | 90%RH | 0.7 | 1.1 | 1.5 | 2.0 | 2.2 | 1.2 | 1.0 | 1.1 |

**[Table 2]**

| | Example No. | | Example 9 | Example 10 | Example 11 | Example 12 | Example 13 | Example 14 | Example 15 |
|---|---|---|---|---|---|---|---|---|---|
| Metal layer (A) | Production Example | | Production Example 6 | Production Example 7 | Production Example 8 | | | | Production Example 1 |
| | Metal | | Zinc oxide | Zinc oxide | Zinc oxide | Zinc oxide | Zinc oxide | Zinc oxide | Zinc oxide |
| | Method | | PVD | PVD | PVD | Sputtering | Sputtering | Sputtering | Sputtering |
| | Thickness (nm) | | 100 | 50 | 20 | 100 | 50 | 20 | 100 |
| Layer (B) | Preparation liquid 1 | | 37 | 37 | 37 | 37 | 37 | 37 | |
| | Preparation liquid 2 | | | | | | | | 100 |
| | Water | | 59 | 59 | 59 | 59 | 59 | 59 | |
| | Succinic acid | | | | | | | | |
| | BTCA | | | | | | | | |
| | Citric acid | | 1.85 | 1.85 | 1.85 | 1.85 | 1.85 | 1.85 | |
| | Polycarboxylic acid in solids | | 50% | 50% | 50% | 50% | 50% | 50% | 100% |
| Evaluation of barrier properties | OTR | 0%RH | 0.03 | 0. 06 | 0. 08 | 0. 08 | 0.2 | 0.23 | 0.1 |
| | | 90%RH | 0. 08 | 0.1 | 0.2 | 1.0 | 1.6 | 1.8 | 0.1 |
| | MVTR | 90%RH | 0.6 | 0.8 | 0.9 | 1.9 | 2 | 2.1 | 0.6 |

**[Table 3]**

| | Comparative Example No. | | Comparative Example 1 | Comparative Example 2 | Comparative Example 3 |
|---|---|---|---|---|---|
| Metal layer (A) | Production Example | | - | Production Example 1 | Production Example 12 |
| | Metal | | None | Zinc oxide | Zinc oxide |
| | Method | | - | Sputtering | Application |
| | Thickness (nm) | | - | 100 | 200 |
| Layer (B) | Preparation liquid 1 | | 37 | 100 | 37 |
| | Water | | 59 | | 59 |
| | Succinic acid | | | | |
| | Citric acid | | 4.3 | | 4.3 |
| | Polycarboxylic acid in solids | | 70% | 0% | 70% |
| Evaluation of barrier properties | OTR | 0%RH | 0.5 | 0.35 | 2.4 |
| | | 90%RH | 11.0 | 14.0 | 8.0 |
| | MVTR | 90%RH | 2.3 | 2.7 | 2.4 |

### INDUSTRIAL APPLICABILITY

The laminated material of the invention exhibits excellent gas barrier properties due to the composition thereof. Therefore, the laminated material of the invention can be advantageously used as a packaging material, especially as a packaging material that requires barrier properties, such as a packaging material for foods, articles for daily use, electronic materials, or products for medical use.

## Claims

1. A gas barrier laminated material having:
a metal layer (A) formed by a vapor phase thin film formation method, and
a layer (B) formed from a compound having a carboxyl group in the structure thereof,
the metal layer (A) and the layer (B) being laminated.

2. The gas barrier laminated material according to claim 1, wherein the metal layer (A) is a layer formed from at least one member selected from the group consisting of a metal oxide, a metal hydroxide, and a metal salt.

3. The gas barrier laminated material according to claim 1 or 2, wherein the metal layer (A) is a metal layer formed from at least one metal oxide selected from zinc oxide, magnesium oxide, and calcium oxide.

4. The gas barrier laminated material according to any one of claims 1 to 3, wherein the vapor phase thin film formation method is a physical vapor deposition method.

5. The gas barrier laminated material according to any one of claims 1 to 4, wherein the compound having a carboxyl group in the structure thereof is a polycarboxylic acid compound having two or more carboxyl groups in the molecule thereof.

6. The gas barrier laminated material according to any one of claims 1 to 5, which further has a resin film substrate layer.

7. A packaging material comprising the gas barrier laminated material according to any one of claims 1 to 6.
